# EUROPÄISCHE PATENTSCHRIFT

(11) **EP 1 764 907 B1**
(45) Veröffentlichungstag und Bekanntmachung des Hinweises auf die Patenterteilung: **17.09.2008**
(21) Anmeldenummer: 06017940.5
(22) Anmeldetag: 29.08.2006
(51) Int. Cl.: H02P 8/36, H02H 3/087, H02M 7/515, H03K 17/08, H02H 9/02

(54) **Redundantes elektromotorisches Antriebssystem**
Redundant electromotoric drive system
Système d'entraînement électromoteur redondant

(30) Priorität: 16.09.2005 DE 102005044526
(43) Veröffentlichungstag der Anmeldung: 21.03.2007
(73) Patentinhaber: Deutsches Zentrum für Luft- und Raumfahrt e.V., 51147 Köln (DE)
(72) Erfinder: Gruber, Robin, Dipl.-Ing., 81371 München (DE); Sedlmayr, Hans-Jürgen, Dipl.-Ing., 86928 Hofstetten (DE)
(74) Vertreter: von Kirschbaum, Albrecht

(56) Entgegenhaltungen:
- JP-A- 2 119 530
- JP-A- 5 276 657
- JP-A- 9 018 311
- JP-A- 55 063 586

## Beschreibung

Die Erfindung betrifft ein redundantes elektromotorisches Antriebssystem, dessen redundante Komponenten mechanisch gekoppelt sind und in den Motorstromzuleitungen zur Motorsteuerung Motor-Umrichter/-Treiber aufweisen, die jeweils einen High-Side-Treiber und einen Low-Side-Treiber enthalten, wobei die Motor-Umrichter/-Treiber jeweils eine an elektronischen Halbbrücken-Schaltelementen vom High-Side-Treiber bzw. Low-Side-Treiber angesteuerte Halbbrücke enthalten, die zur jeweiligen Motorstromzuleitung hin um ein zusätzliches elektronisches Schaltelement ergänzt ist, das entweder direkt oder unter galvanischer Trennung oder mittels Transformatorkopplung über die High-Side-Treiber und Low-Side-Treiber ansteuerbar ist.

Ein derartiges redundantes elektromagnetisches Antriebssystem ist aus JP 55 063586 (Fujitsu Fanuc Ltd.) bekannt.

In Applikationen bei Weltraumanwendungen oder auf anderen Einsatzgebieten, bei denen ein Totalausfall einer Baugruppe oder eines Bauteils eines Geräts nicht tolerierbar ist, werden so genannte redundante Systeme eingesetzt. Es werden hierzu kritische Baugruppen oder Bauteile mehrfach eingebaut und zwar in einer solchen Weise, dass die Aufgabe einer ausgefallenen Komponente durch eine andere übernommen werden kann.

Problematisch wird diese Sicherheitsmaßnahme, sobald elektromotorische Antriebssysteme redundant ausgelegt werden sollen, deren redundante Komponenten auf einer gemeinsamen Welle sitzen, also z.B. bei einem Motor mit zwei Umrichtern/Treibern, einem Motor mit zwei Wicklungen oder bei zwei gekoppelten Motoren. Dreht sich die Welle infolge Antriebs durch eine der beiden redundanten Komponenten, so wird im zweiten Motor, in der zweiten Wicklung oder im zweiten Umrichter/Treiber eine Spannung induziert.

Liegt nun ein Defekt dergestalt vor, dass ein elektronisches Schaltelement, z.B. ein MOSFET-Transistor, ein bipolarer Transistor, ein IGBT (Isolated Gate Bipolar Transistor) oder ein GTO(Gate Turn Off)-Thyristor, im aktuell passiven Umrichter einen Kurzschluss aufweist oder die Versorgungsspannung des passiven Umrichters zusammengebrochen ist, so fließt in diesen auf Grund der durch die Wellendrehung darin induzierten Spannung ein erheblicher Strom, der ein Bremsen der Welle verursacht und einen normalen Betrieb der gesamten motorischen Antriebsanordnung verhindert.

Dieses Problem kann entweder dadurch umgangen werden, dass der Umrichter/Treiber stets selbst komplett redundant ausgelegt wird, was mindestens die doppelte Anzahl an elektronischen Schalt- und Bauelementen - verbunden mit einer aufwändigeren Ansteuerung und mehr Platzbedarf - erfordert, oder es muss ein elektromechanisches Relais eingesetzt werden, welches den unbenutzten Umrichter/Treiber vom Motor trennt.

Alternativ werden auch andere elektrische Motorsysteme verwendet, welche den generatorischen Betrieb bauartlich bedingt umgehen oder ein Drehen auch bei kurzgeschlossener Wicklung ermöglichen. Allerdings ist damit üblicherweise ein schlechterer Wirkungsgrad verbunden.

Redundante elektromotorische Antriebssysteme mit den angegebenen Nachteilen sind beispielsweise aus EP 0 343 397 B1 und WO-A-8702106 bekannt.

Der Erfindung liegt die Aufgabe zu Grunde, redundante elektromotorische Antriebssysteme unter Verwendung gewöhnlicher gesteuerter Elektromotoren so weiterzubilden, dass bei sehr geringem zusätzlichen technischen Aufwand im Falle eines Ausfalls eines elektronischen Schaltelements in einem der redundanten Antriebe an der gemeinsamen Welle kein störendes Bremsen infolge der Wirkung eines generatorischen Betriebs auftritt und somit ein einwandfreier, vorschriftsmäßiger Motorbetrieb sichergestellt ist, wobei der Wirkungsgrad nahezu erhalten bleibt.

Gemäß der Erfindung, die sich auf ein redundantes elektromotorisches Antriebssystem der eingangs genannten Art bezieht, wird diese Aufgabe dadurch gelöst, dass im Fall einer direkten Ansteuerung des zusätzlichen elektronischen Schaltelements an dessen Gate-Elektrode diese Ansteuerung in vorteilhafter Weise über eine Diodenmatrix durch dieselben High-Side-Treiber und Low-Side-Treiber vorgenommen wird, welche auch die beiden elektronischen Halbbrücken-Schaltelemente ansteuern.

Im Falle einer unter galvanischer Trennung erfolgenden Ansteuerung des zusätzlichen elektronischen Schaltelements an dessen Gate-Elektrode wird diese Ansteuerung zweckmäßig über einen photovoltaischen oder gewöhnlichen Optokoppler vorgenommen.

Zur optischen Kopplung kann ein Photo-MOS-Relais oder ein Solid-State-Relais vorgesehen werden, das aus der Motorbrückenspannung oder über eine zusätzliche Schalteinrichtung, welche im Normalbetrieb das zusätzliche elektronische Schaltelement leitend schaltet, gesteuert wird.

Im Falle einer mittels Transformatorkopplung erfolgenden Ansteuerung des zusätzlichen elektronischen Schaltelements an dessen Gate-Elektrode sind zweckmäßig auf der Primärseite des Transformators zur Wechselspannungsversorgung ein Zerhacker und sekundärseitig ein Gleichrichter vorgesehen, welcher als Synchrongleichrichter oder passiver Gleichrichter ausgeführt ist.

Der Zerhacker wird dann entweder durch die Motorbrückenschaltung oder eine zusätzliche Schalteinrichtung, welche im Normalbetrieb das zusätzliche elektronische Schaltelement leitend schaltet, gesteuert.

Parallel zum Gate des zusätzlichen elektronischen Schaltelements sind in vorteilhafter Weise ein Kondensator und parallel dazu vorzugsweise ein ohmscher Widerstand angeordnet, was bewirkt, dass das zusätzliche elektronische Schaltelement auch nach dem Abschalten der elektronischen Halbbrücken-Schaltelemente zumindest noch für kurze Dauer leitend bleibt, so dass Ströme durch Motorinduktivitäten abgebaut werden können.

Bei bürstenbehafteten Gleichstrommotoren sind zwei jeweils mit einem zusätzlichen elektronischen Schaltelement versehene Halbbrücken nach der Erfindung vorgesehen, d.h. in jedem Motorstromzuführungsleiter eine solche Halbbrücke.

Bei bürstenlosen Motoren ist für jede der Phasen eine mit einem zusätzlichen elektronischen Schaltelement versehene Halbbrücke nach der Erfindung vorgesehen und bei Schrittmotoren werden für jede der beiden Phasen jeweils zwei mit einem zusätzlichen elektronischen Schaltelement versehene Halbbrücken nach der Erfindung eingesetzt.

Vorteilhafte und zweckmäßige Weiterbildungen und Ausgestaltungen der Erfindung sind in den unmittelbar oder mittelbar auf den Patentanspruch 1 rückbezogenen Unteransprüchen angegeben.

Die Erfindung wird nachfolgend anhand von in Zeichnungen dargestellten, vorteilhaften Ausführungsbeispielen erläutert. Es zeigen:
- Fig.1: in einem vereinfachten Blockschaltbild eine erste Realisierungsform einer im Fehlerfall passiven Halbbrücke,
- Fig.2: in einem vereinfachten Blockschaltbild eine zweite Realisierungsform einer im Fehlerfall passiven Halbbrücke,
- Fig.3: in einem vereinfachten Blockschaltbild eine dritte Realisierungsform einer im Fehlerfall passiven Halbbrücke,
- Fig.4: in einem vereinfachten Blockschaltbild die erfindungsgemäße Ansteuerung eines Gleichstrom-Bürstenmotors,
- Fig.5: ebenfalls in einem vereinfachten Blockschaltbild die erfindungsgemäße Ansteuerung eines bürstenlosen Motors, und
- Fig.6: ebenso in einem vereinfachten Blockschaltbild die erfindungsgemäße Ansteuerung eines Schrittmotors.

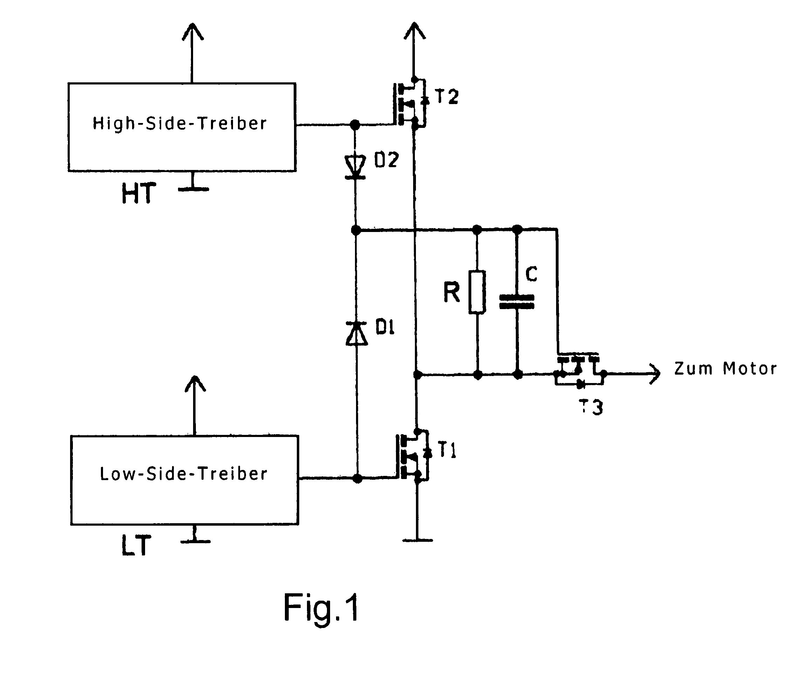

Die in den Fig.1, Fig.2 und Fig.3 dargestellten Motor-Umrichter/Treiber enthalten zur Motorsteuerung in typischer Weise einen High-Side-Treiber 1 und einen Low-Side-Treiber 2. Eine mit zwei n-Kanal-MOSFET-Transistoren als elektronische Schaltelemente T1 und T2 versehene Halbbrücke wird vom High-Side-Treiber HT und Low-Side-Treiber LT angesteuert. Die Halbbrücken der drei in Fig.1, Fig.2 bzw. Fig.3 dargestellten Motor-Umrichter/-Treiber sind jeweils um ein zusätzliches elektronisches Schaltelement T3 ergänzt, welches also die Halbbrücke jeweils modifiziert und an seinem Gate angesteuert wird. Dabei sind in Fig.1 bis Fig.3 ohne Beschränkung der Allgemeinheit als Schaltelemente T1, T2 und T3 immer n-Kanal-MOSFET-Transistoren gezeichnet. Eine Verwendung von p-Kanal-MOSFETS, bipolaren Transistoren, IGBTs oder GTOs ist jedoch ebenfalls möglich.

Es werden hier drei Varianten zur Ansteuerung des zusätzlichen elektronischen Schaltelements T3, welches in der Motorstromzuleitung liegt, vorgeschlagen.

Fig.1 zeigt als erste Variante eine direkte Ansteuerung des zusätzlichen elektronischen Schaltelements über den bereits in einem typischen Motor-Umrichter/-Treiber enthaltenen High-Side-Treiber HT und Low-Side-Treiber LT. Im normalen Betrieb des Motor-Umrichters/-Treibers wird das zusätzliche elektronische Schaltelement T3 leitend geschaltet. Dies kann mit einer aus zwei Dioden D1 und D2 zusammengesetzten Diodenmatrix durch dieselben High- und Low-Side-Treiber HT und LT geschehen, welche auch die elektronischen Schaltelemente T1 und T2 ansteuern. Sobald also die Schaltelemente T1 oder T2 leitend geschaltet werden, wird auch das Gate des zusätzlichen elektronischen Schaltelements T3 aufgeladen und dieses leitet. Ein parallel zum Gate des zusätzlichen elektronischen Schaltelements T3 angeordneter Kondensator C, dem noch ein ohmscher Widerstand R parallel geschaltet ist, hält das zusätzliche elektronische Schaltelement T3 auch nach dem Abschalten der elektronischen Schaltelemente T1 und T2 zumindest noch eine kurze Zeit leitend, so dass Ströme durch Motorinduktivitäten abgebaut werden können.

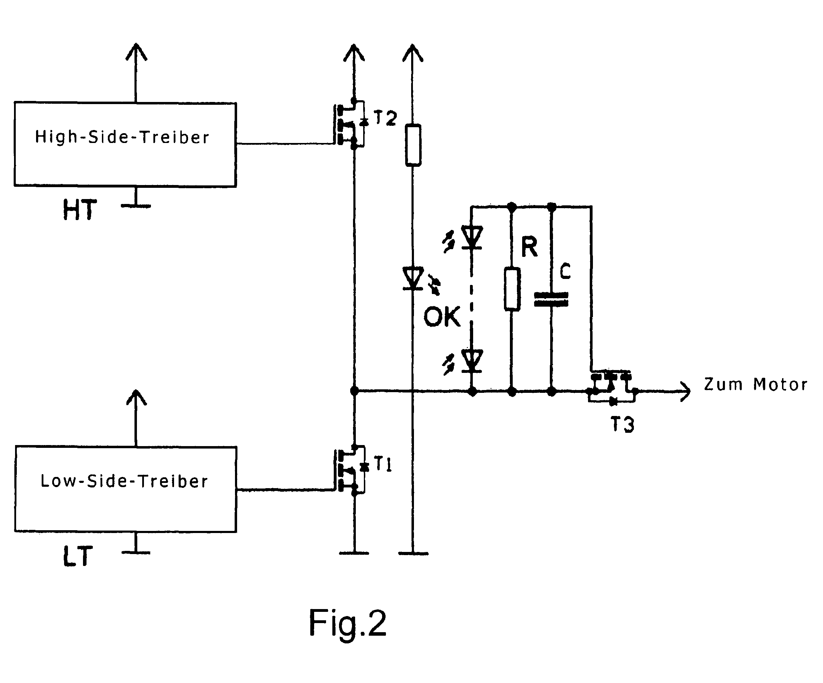

Wie Fig.2 in einer zweiten Variante zeigt, ist auch eine galvanisch getrennte Ansteuerung des zusätzlichen elektronischen Schaltelements T3 und zwar über einen photovoltaischen oder normalen Optokoppler OK, beispielsweise in Form eines Solid-State- oder Photo-MOS-Relais, möglich. Es kann also alternativ das zusätzliche elektronische Schaltelement T3 durch ein Photo-MOS-Relais oder ein Solid-State-Relais geschaltet werden, welches aus der Motorbrückenspannung oder über eine zusätzliche Schalteinrichtung, die im Normalbetrieb das zusätzliche elektronische Schaltelement T3 leitend schaltet, gesteuert wird.

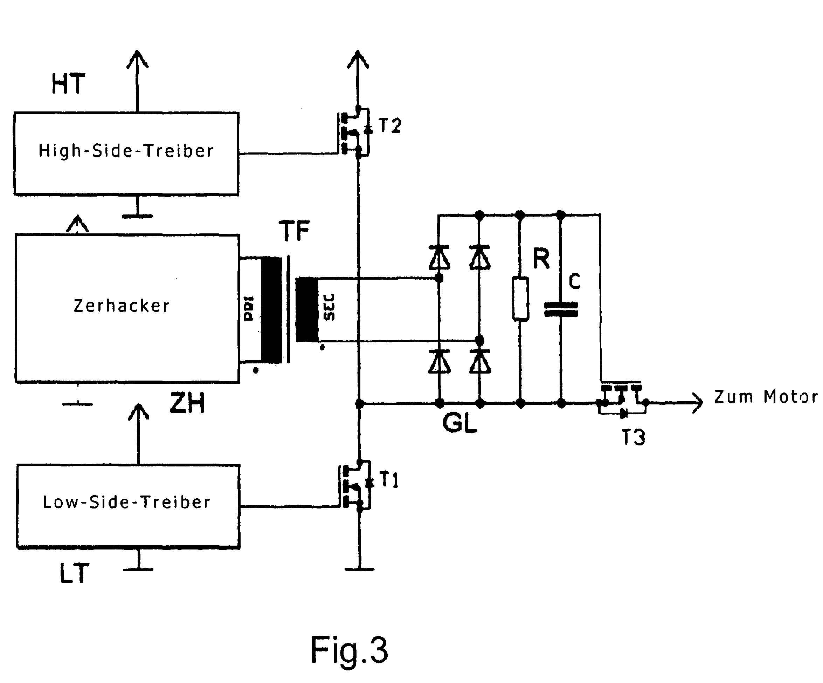

Wie Fig.3 in einer dritten Variante zeigt, ist auch eine Ansteuerung über einen Transformator TF mit eingangsseitigem Zerhacker ZH und ausgangsseitigem Gleichrichter GL möglich, welcher als Synchrongleichrichter oder passiver Gleichrichter ausgeführt sein kann. Bei dieser dritten Variante wird das Gate des zusätzlichen elektronischen Schaltelements T3 über den Transformator TF mit nachgeschaltetem Gleichrichter GL geladen, dessen Primärseite durch den Zerhacker ZH versorgt wird, welcher ebenfalls wieder entweder durch die Brückenspannung oder durch eine zusätzliche Schalteinrichtung, die im Normalbetrieb das zusätzliche elektronische Schaltelement T3 leitend schaltet, angesteuert wird.

Im Zusammenhang mit den in Fig.1, Fig.2 und Fig.3 gezeigten Ausführungsbeispielen wird hier angemerkt, dass Elemente zur Strommessung, Snubber-Netzwerke, Filter, Zwischenkreis-Kondensatoren oder dergleichen für das Prinzip der Erfindung nicht relevant und daher in den genannten Figuren der Einfachheit halber nicht eingezeichnet sind.

Damit leitet bei allen drei Varianten nach Fig.1 bis 3 das zusätzliche elektronische Schaltelement T3 und zwar aufgrund seiner Konstruktion im geschalteten Zustand in beiden Richtungen und stört die normale Funktion des Motor-Umrichters/-Treibers nicht.

Fällt nun eines der beiden elektronischen Halbbrücken-Schaltelemente T1 und T2 aus oder fallen gar beide so aus, dass darin ein Leerlauf erzeugt wird, so funktioniert der Motor-Umrichter/-Treiber nicht mehr, stört aber eine von extern anliegende Spannung nicht.

Fällt eines der beiden elektronischen Halbbrücken-Schaltelemente T1 und T2 aus, so dass ein Kurzschluss erzeugt wird, so fließt beim nächsten Schalten des jeweils anderen Halbbrücken-Transistors T1 bzw. T2 ein sehr hoher Strom. Entweder führt das zum permanenten Abfall der Zwischenkreisspannung oder es wird von der Umrichtersteuerung auf Fehler erkannt und die Stromversorgung zum Zwischenkreis unterbrochen und dabei gegebenenfalls die Ansteuerung des zusätzlichen elektronischen Schaltelements T3 abgeschaltet.

Sperrt das zusätzliche elektronische Schaltelement T3, so hat eine externe Spannung zwischen zwei oder mehr Phasen keinen Stromfluss zur Folge, da mindestens eine der Body-Dioden des zusätzlichen elektronischen Schaltelements T3 in Sperrrichtung geschaltet ist.

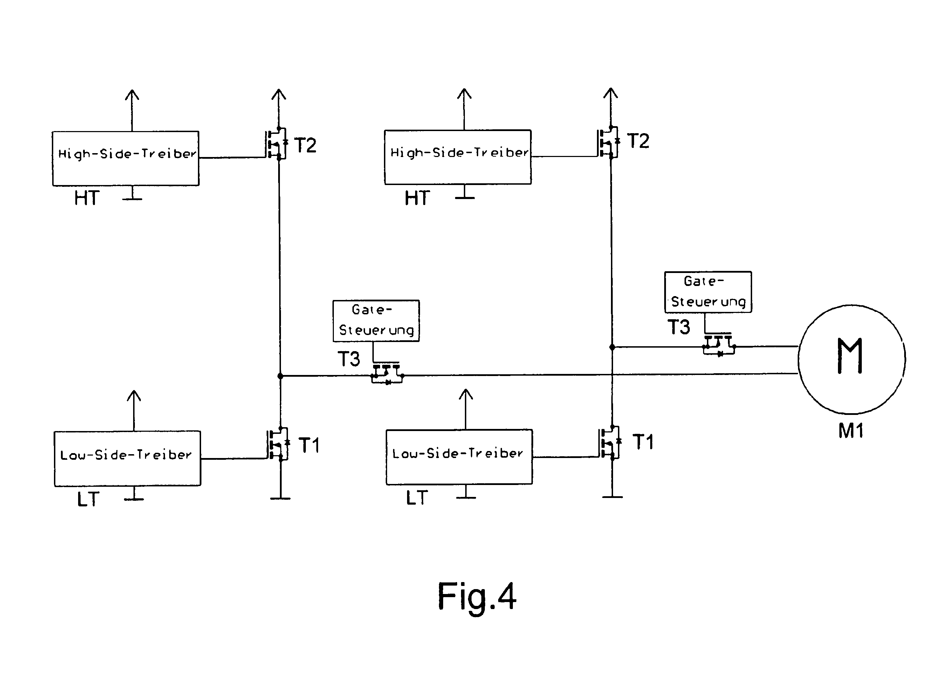

In Fig.4 ist schematisch in einem Blockschaltbild die Realisierung einer erfindungsgemäß ausgebildeten Ansteuerung eines mit Bürsten ausgestatteten Gleichstrommotors M1 dargestellt. Für den Betrieb von bürstenbehafteten Gleichstrommotoren sind zwei der vorher anhand von Fig.1 bis Fig.3 beschriebenen, von jeweils einem High-Side-Treiber HT und einem Low-Side-Treiber LT angesteuerten Halbbrücken erforderlich, wobei jeweils eine dieser mit dem zusätzlichen elektronischen Schaltelement T3 versehenen Halbbrücken in jeweils einem der beiden Motor-Stromzuführungsleiter angeordnet ist.

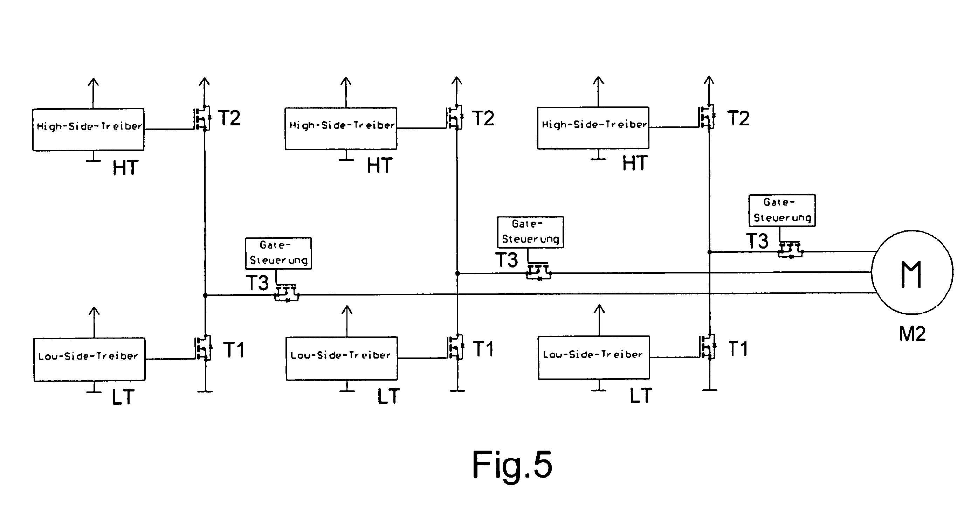

In Fig.5 ist schematisch in einem weiteren Blockschaltbild die Realisierung einer erfindungsgemäß ausgebildeten Ansteuerung eines bürstenlosen Motors M2 dargestellt. Für den Betrieb von bürstenlosen Gleichstrommotoren ist für jede der in diesem Fall drei Phasen eine der vorher anhand von Fig.1 bis Fig.3 beschriebenen, von jeweils einem High-Side-Treiber HT und einem Low-Side-Treiber LT angesteuerten Halbbrücken erforderlich, wobei jeweils eine dieser mit dem zusätzlichen elektronischen Schaltelement T3 versehenen Halbbrücken in jeweils einer der drei Motor-Stromzuführungsphasen angeordnet ist.

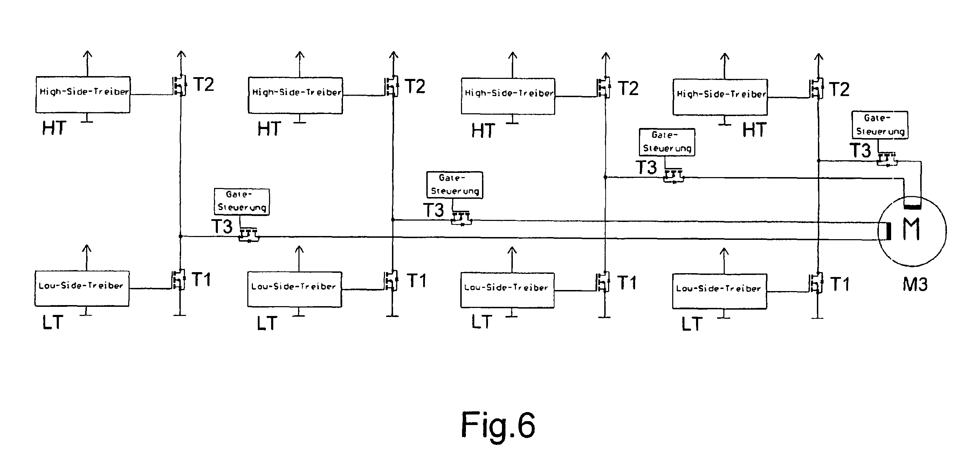

Fig.6 ist in einem weiteren Blockschaltbild schematisch die Realisierung einer erfindungsgemäß ausgebildeten Ansteuerung eines Schrittmotors M3 dargestellt. Für den Betrieb von Schrittmotoren werden für jede Phase jeweils zwei der vorher anhand von Fig.1 bis Fig.3 beschriebenen, von jeweils einem High-Side-Treiber HT und einem Low-Side-Treiber LT angesteuerte Halbbrücken benötigt, wobei jeweils zwei dieser mit dem zusätzlichen elektronischen Schaltelement T3 versehenen Halbbrücken eine der beiden Motor-Stromzuführungsphasen zugeordnet ist.

### Bezugszeichenliste

- D1, D2: Dioden einer Diodenmatrix
- GL: Gleichrichter
- HT: High-Side-Treiber
- LT: Low-Side-Treiber
- M1: Gleichstrommotor
- M2: Bürstenloser Motor
- M3: Schrittmotor
- OK: Optokoppler
- R: Ohmscher Widerstand
- T1, T2: Elektronische Schaltelemente
- T3: Zusätzliches elektronisches Schaltelement
- TF: Transformator
- ZH: Zerhacker

## Patentansprüche

1. Redundantes elektromotorisches Antriebssystem, dessen redundante Komponenten mechanisch gekoppelt sind und in den Motorstromzuleitungen zur Motorsteuerung Motor-Umrichter/-Treiber aufweisen, die jeweils einen High-Side-Treiber und einen Low-Side-Treiber enthalten, wobei die Motor-Umrichter/-Treiber jeweils eine an elektronischen Halbbrücken-Schaltelementen (T1, T2) vom High-Side-Treiber (HT) bzw. Low-Side-Treiber (LT) angesteuerte Halbbrücke enthalten, die zur jeweiligen Motorstromzuleitung hin um ein zusätzliches elektronisches Schaltelement (T3) ergänzt ist, das entweder direkt oder unter galvanischer Trennung oder mittels Transformatorkopplung über die High-Side-Treiber und Low-Side-Treiber ansteuerbar ist, **dadurch gekennzeichnet, dass** die direkte Ansteuerung des zusätzlichen elektronischen Schaltelements (T3) an dessen Gate-Elektrode über eine Diodenmatrix (D1, D2) durch dieselben High-Side-Treiber (HT) und Low-Side-Treiber (LT) vorgenommen ist, welche auch die beiden elektronischen Halbbrücken-Schaltelemente (T1, T2) ansteuern.

2. Redundantes elektromotorisches Antriebssystem nach Anspruch 1, **dadurch gekennzeichnet, dass** die unter galvanischer Trennung erfolgende Ansteuerung des zusätzlichen elektronischen Schaltelements (T3) an dessen Gate-Elektrode über einen photovoltaischen oder gewöhnlichen Optokoppler (OK) vorgenommen ist.

3. Redundantes elektromotorisches Antriebssystem nach Anspruch 2, **dadurch gekennzeichnet, dass** zur optischen Kopplung als Optokoppler (OK) ein Photo-MOS-Relais oder ein Solid-State-Relais vorgesehen ist, das aus der Motorbrückenspannung oder über eine zusätzliche Schalteinrichtung, welche im Normalbetrieb das zusätzliche elektronische Schaltelement (T3) leitend schaltet, gesteuert ist.

4. Redundantes elektromotorisches Antriebssystem nach Anspruch 1, **dadurch gekennzeichnet, dass** bei der mittels Transformatorkopplung erfolgenden Ansteuerung des zusätzlichen elektronischen Schaltelements (T3) an dessen Gate-Elektrode auf der Primärseite des Transformators (TF) zur Wechselspannungsversorgung ein Zerhacker (ZH) und sekundärseitig ein Gleichrichter (GL) vorgesehen sind, welcher als Synchrongleichrichter oder passiver Gleichrichter ausgeführt ist.

5. Redundantes elektromotorisches Antriebssystem nach Anspruch 4, **dadurch gekennzeichnet, dass** der Zerhacker (ZH) entweder durch die Motorbrückenschaltung oder eine zusätzliche Schalteinrichtung, welche im Normalbetrieb das zusätzliche elektronische Schaltelement (T3) leitend schaltet, gesteuert ist.

6. Redundantes elektromotorisches Antriebssystem nach einem der vorhergehenden Ansprüche, **dadurch gekennzeichnet, dass** parallel zum Gate des zusätzlichen elektronischen Schaltelements (T3) ein Kondensator (C) und vorzugsweise parallel dazu ein ohmscher Widerstand (R) angeordnet sind.

7. Redundantes elektromotorisches Antriebssystem nach einem der vorhergehenden Ansprüche, **dadurch gekennzeichnet, dass** bei bürstenbehafteten Gleichstrommotoren (M1) zwei jeweils mit einem zusätzlichen elektronischen Schaltelement (T3) versehene Halbbrücken vorgesehen sind, d.h. in jedem Motorstromzuführungsleiter eine solche Halbbrücke.

8. Redundantes elektromotorisches Antriebssystem nach einem der Ansprüche 1 bis 6, **dadurch gekennzeichnet, dass** bei bürstenlosen Motoren (M2) für jede der Phasen eine mit einem zusätzlichen elektronischen Schaltelement (T3) versehene Halbbrücke vorgesehen ist.

9. Redundantes elektromotorisches Antriebssystem nach einem der Ansprüche 1 bis 6, **dadurch gekennzeichnet, dass** bei Schrittmotoren (M3) für jede der beiden Phasen jeweils zwei mit einem zusätzlichen elektronischen Schaltelement (T3) versehene Halbbrücken vorgesehen sind.

## Claims

1. A redundant electromotoric drive system, whose redundant components are mechanically coupled and have their motor current supply lines provided with a motor inverter/driver for motor control, each comprising a high-side driver and a low-side driver, said motor inverters/drivers each including a half-bridge driven by the high-side driver (HT) and the low-side driver (LT) at electronic half-bridge switching elements, said half-bridge being completed towards the respective motor current supply line by an additional electronic switching element (T3) that can be driven through the high-side drivers and the low-side drivers either directly or under galvanic separation or by means of transformer coupling, **characterized in that** the direct driving of the additional electronic switching element (T3) is effected at its gate electrode via a diode matrix (D1, D2) by means of the same high-side drivers (HT) and low-side drivers (LT) that also drive the two electronic half-bridge switching elements (T1, T2).

2. The redundant electromotoric drive system of claim 1, **characterized in that** driving the additional electronic switching element (T3) under galvanic separation is effected at its gate electrode via a photovoltaic or a conventional optocoupler (OK).

3. The redundant electromotoric drive system of claim 2, **characterized in that** a photo-MOS-relay or a solid state relay is provided as an optocoupler (OK) for optocoupling, which relay is controlled by the motor bridge voltage or through an additional switching means that, in normal operation, switches the additional switching element (T3) into the conducting state.

4. The redundant electromotoric drive system of claim 1, **characterized in that,** when driving the additional electronic switching element (T3) by transformer coupling, at the gate electrode of the element a chopper (ZH) is provided on the primary side of the transformer (TF) for AC voltage supply and a rectifier (GL) is provided on the secondary side that is configured as a synchronous rectifier or a passive rectifier.

5. The redundant electromotoric drive system of claim 4, **characterized in that** the chopper (ZH) is controlled either by the motor bridge circuit or an additional switching means that, in normal operation, switches the electronic switching element (T3) into the conducting state.

6. The redundant electromotoric drive system of claim 1, **characterized in that** a capacitor (C) and, preferably in parallel therewith, an ohmic resistance (R) are arranged in parallel with the gate of the additional electronic switching element (T3).

7. The redundant electromotoric drive system of one of the preceding claims, **characterized in that** with brush-equipped DC motors (M1), two half-bridges, each provided with an additional electronic switching element (T3), are provided, i.e. one such half-bridge in each motor current supply line.

8. The redundant electromotoric drive system of one of claims 1 to 6, **characterized in that** with brushless motors (M2), a half-bridge equipped with an additional electronic switching element (T3) is provided for each phase.

9. The redundant electromotoric drive system of one of claims 1 to 6, **characterized in that** with stepping motors (M3), two respective half-bridges equipped with an additional electronic switching element (T3) are provided for each of the two phases.

## Revendications

1. Système d'entraînement électromoteur redondant, dont les composants redondants sont couplés mécaniquement et présentent dans les lignes d'alimentation du moteur pour la commande du moteur des entraîneurs/convertisseurs de moteur qui contiennent respectivement un entraîneur high side et un entraîneur low side, les entraîneurs/convertisseurs de moteur contenant un demi-pont commandé sur des éléments de commutation de demi-pont (T1, T2) électroniques de l'entraîneur high side (HT) ou de l'entraîneur low side (LT), lequel est complété vers la ligne d'alimentation du moteur respectif d'un élément de commutation (T3) électronique supplémentaire qui peut être commandé directement ou par séparation galvanique ou au moyen d'un couplage en transformateur par les entraîneurs high side ou entraîneurs low side, **caractérisé en ce que** l'élément de commutation (T3) électronique supplémentaire est commandé directement sur son électrode porte par le biais d'une matrice de diodes (D1, D2) par les mêmes entraîneurs high side (HT) et entraîneurs low side (LT) qui commandent également les deux éléments de commutation de demi-pont (T1, T2) électroniques.

2. Système d'entraînement électromoteur redondant selon la revendication 1, **caractérisé en ce que** la commande s'effectuant par séparation galvanique de l'élément de commutation (T3) électronique supplémentaire est entreprise sur son électrode porte par le biais d'un optocoupleur (OK) photovoltaïque ou habituel.

3. Système d'entraînement électromoteur redondant selon la revendication 2, **caractérisé en ce que** pour le couplage optique comme optocoupleur (OK) est prévu un relais photo MOS ou un relais solid state qui est commandé à partir de la tension du pont de moteur ou par le biais d'un dispositif de commutation supplémentaire qui commute de manière conductrice en mode normal l'élément de commutation (T3) électronique supplémentaire.

4. Système d'entraînement électromoteur redondant selon la revendication 1, **caractérisé en ce que** lors de la commande s'effectuant au moyen du couplage en transformateur de l'élément de commutation (T3) électronique supplémentaire, un hacheur (ZH) est prévu sur son électrode porte sur le côté primaire du transformateur (TF) pour l'alimentation en courant alternatif et côté secondaire un redresseur (GL) qui est réalisé comme un redresseur synchrone ou un redresseur passif.

5. Système d'entraînement électromoteur redondant selon la revendication 4, **caractérisé en ce que** le hacheur (ZH) est commandé par le circuit en pont du moteur ou un dispositif de commutation supplémentaire qui commute de manière conductrice en mode normal l'élément de commutation (T3) électronique supplémentaire.

6. Système d'entraînement électromoteur redondant selon l'une quelconque des revendications précédentes, **caractérisé en ce que** parallèlement à la porte de l'élément de commutation (T3) électronique supplémentaire sont disposés un condensateur (C) et, de préférence parallèlement à celui-ci, une résistance ohmique (R).

7. Système d'entraînement électromoteur redondant selon l'une quelconque des revendications précédentes, **caractérisé en ce que** pour des moteurs à courant continu (M1) chargés de balais, deux demi-ponts pourvus respectivement d'un élément de commutation (T3) électronique supplémentaire sont prévus, c'est-à-dire dans chaque conducteur de ligne d'alimentation du moteur, un tel demi-pont.

8. Système d'entraînement électromoteur redondant selon l'une quelconque des revendications 1 à 6, **caractérisé en ce que** pour des moteurs (M2) sans balais, un demi-pont pourvu d'un élément de commutation (T3) électronique supplémentaire est prévu pour chacune des phases.

9. Système d'entraînement électromoteur redondant selon l'une quelconque des revendications 1 à 6, **caractérisé en ce que** pour des moteurs pas à pas (M3), respectivement deux demi-ponts pourvus d'un élément de commutation (T3) électronique supplémentaire sont prévus pour chacune des deux phases.
